# EUROPEAN PATENT APPLICATION

(11) **EP 3 131 119 A1**
(43) Date of publication of application: **15.02.2017**
(21) Application number: 16182298.6
(22) Date of filing: 02.08.2016
(51) Int. Cl.: H01L 27/12, H01L 21/84, H01L 21/762, H01L 29/786

(54) **SOI SEMICONDUCTOR DEVICE AND MANUFACTURING METHOD OF THE SAME**

(30) Priority: 10.08.2015 JP 2015158206
(71) Applicant: Renesas Electronics Corporation, Tokyo 135-0061 (JP)
(72) Inventor: ODA, Hidekazu, Tokyo, 135-0061 (JP)
(74) Representative: Betten & Resch

(57) **Abstract**

Performance of a semiconductor device is improved.

An element isolation portion includes a projection portion that projects from an SOI substrate and comes into contact with a piled-up layer. The height of the upper surface of the projection portion is configured to be lower than or equal to the height of the upper surface of the piled-up layer and higher than or equal to a half of the height of the upper surface of the piled-up layer with reference to a surface of a silicon layer of the SOI substrate.

## Description

### CROSS-REFERENCE TO RELATED APPLICATIONS

The disclosure of Japanese Patent Application No. 2015-158206 filed on August 10, 2015 including the specification, drawings and abstract is incorporated herein by reference in its entirety.

### BACKGROUND

The present invention relates to a semiconductor device and a manufacturing method thereof, and, for example, relates to a technique effective to apply to a field-effect transistor including a piled-up layer formed over a substrate having a structure called FD-SOI (Fully-Depleted Silicon on Insulator: Fully-Depleted SOI), more specifically a structure called SOTB (Silicon on thin buried oxide), as a constituent element, and a manufacturing method of the field-effect transistor.

Japanese Unexamined Patent Application Publication No. 2014-236097 (Patent Literature 1) and U.S. Patent Application Publication No. 2012/0252174 (Patent Literature 2) disclose a semiconductor device where a surface of an SOI substrate and a surface of an element isolation region are the same surface and which has a structure in which a piled-up layer that forms a part of a source region or a part of a drain region of a field-effect transistor is formed over the SOI substrate.

U.S. Patent Application Publication No. 2015/0011070 (Patent Literature 3) discloses a semiconductor device having a structure in which a piled-up layer protruding higher than a surface of an element isolation region is formed over a semiconductor substrate.

U.S. Patent Application Publication No. 2014/0054699 (Patent Literature 4) discloses a semiconductor device having a structure in which a piled-up layer is formed over a surface of an SOI substrate and a surface of an element isolation region is slightly higher than a surface of a silicon layer of the SOI substrate.

### SUMMARY

A field-effect transistor is miniaturized based on a scaling law to realize high integration of semiconductor device. However, in a miniaturized field-effect transistor, short channel effect and variation of threshold voltage become obvious, so that it causes degradation in performance of the semiconductor device. In this regard, in a field-effect transistor formed over an SOI substrate, the short channel effect and the variation of threshold voltage are more difficult to be obvious than in a field-effect transistor formed over a semiconductor substrate (bulk substrate), so that the performance of the semiconductor device is excellent. Because of this, it is considered that a technique to form a field-effect transistor over an SOI substrate is required in, for example, semiconductor devices after a generation of circuit line width of about 20 nm.

In particular, when a fully-depleted transistor is employed as a field-effect transistor formed over an SOI substrate, the fully-depleted transistor is excellent in suppressing the short channel effect and does not introduce impurities in a channel region, so that the fully-depleted transistor can sufficiently suppress variation of threshold voltage due to variation of impurities. Therefore, it is possible to provide a semiconductor with excellent performance by employing a fully-depleted transistor.

However, in the fully-depleted transistor, it is required to fully deplete a silicon layer, so that it is required to significantly reduce the thickness of the silicon layer of the SOI substrate. This means that the resistance values of the source region and the drain region formed in the silicon layer become high, and thereby there is a risk to cause performance degradation represented by reduction of the amount of current.

Therefore, it is discussed that a stacked later is formed over the SOI substrate by using, for example, a selective epitaxial method. This is because when the piled-up layer is used as a part of the source region and a part of a drain region, the source region and the drain region are thickened, so that resistances of the regions can be lowered.

However, according to study of the inventors, in the selective epitaxial method, it is newly found that epitaxial growth is suppressed in a boundary region between an element isolation portion and an active region, so that a so-called "facet structure" is formed in which the closer to an element isolation region, the thinner the thickness of the piled-up layer. In the "facet structure", in an ion implantation process, conductive impurities are implanted into a buried insulating layer and a substrate layer of the SOI substrate in a portion whose film thickness is thin. As a result, the inventors newly found that there is room for improvement from the viewpoint of performance improvement and reliability improvement of the semiconductor device. In summary, according to the study of the inventors, it is desired that the shape of the piled-up layer is devised from the viewpoint of performance improvement and reliability improvement of the semiconductor device.

Other problems and novel features will become apparent from the description of the present specification and the accompanying drawings.

In an embodiment, an element isolation portion includes a projection portion that projects from an SOI substrate and comes into contact with a piled-up layer. The height of the upper surface of the projection portion is configured to be lower than or equal to the height of the upper surface of the piled-up layer and higher than or equal to a half of the height of the upper surface of the piled-up layer with reference to a surface of a silicon layer of the SOI substrate.

The element isolation portion includes a projection portion projecting with reference to the surface of the silicon layer. At an end portion of the projection portion, an inclined surface that is continuously inclined upward and in a direction toward the center of the element isolation portion is formed, and the piled-up layer is formed along the inclined surface.

According to an embodiment, it is possible to improve the performance of the semiconductor device. Further, it is possible to improve the reliability of the semiconductor device.

### BRIEF DESCRIPTION OF THE DRAWINGS

Fig. 1 is a schematic cross-sectional view illustrating room for improvement existing in a related art.
Fig. 2 is a cross-sectional view showing a device structure of a semiconductor device according to an embodiment.
Fig. 3 is an enlarged schematic cross-sectional view showing a region close to a boundary region between an element isolation portion and an active region.
Fig. 4 is an enlarged schematic cross-sectional view showing a region close to a boundary region between an element isolation portion and an active region in a modified example 1.
Fig. 5 is an enlarged schematic cross-sectional view showing a region close to a boundary region between an element isolation portion and an active region in a modified example 2.
Fig. 6 is a cross-sectional view showing a manufacturing process of the semiconductor device according to the embodiment.
Fig. 7 is a cross-sectional view showing a manufacturing process of the semiconductor device following Fig. 6.
Fig. 8 is a cross-sectional view showing a manufacturing process of the semiconductor device following Fig. 7.
Fig. 9 is a cross-sectional view showing a manufacturing process of the semiconductor device following Fig. 8.
Fig. 10 is a cross-sectional view showing a manufacturing process of the semiconductor device following Fig. 9.
Fig. 11 is a cross-sectional view showing a manufacturing process of the semiconductor device following Fig. 10.
Fig. 12 is a cross-sectional view showing a manufacturing process of the semiconductor device following Fig. 11.
Fig. 13 is a cross-sectional view showing a manufacturing process of the semiconductor device following Fig. 12.
Fig. 14 is a cross-sectional view showing a manufacturing process of the semiconductor device following Fig. 13.
Fig. 15 is a cross-sectional view showing a manufacturing process of the semiconductor device following Fig. 14.
Fig. 16 is a cross-sectional view showing a manufacturing process of the semiconductor device following Fig. 15.
Fig. 17 is a cross-sectional view showing a manufacturing process of the semiconductor device following Fig. 16.
Fig. 18 is a cross-sectional view showing a manufacturing process of the semiconductor device following Fig. 17.
Fig. 19 is a cross-sectional view showing a manufacturing process of the semiconductor device following Fig. 18.

### DETAILED DESCRIPTION

The following embodiment will be explained, divided into plural sections or embodiments, if necessary for convenience. Except for the case where it shows clearly in particular, they are not mutually unrelated and one has relationships such as a modification, details, and supplementary explanation of some or entire of another.

In the following embodiment, when referring to the number of elements, etc. (including the number, a numeric value, an amount, a range, etc.), they may be not restricted to the specific number but may be greater or smaller than the specific number, except for the case where they are clearly specified in particular and where they are clearly restricted to a specific number theoretically.

Furthermore, in the following embodiment, it is needless to say that an element (including an element step etc.) is not necessarily indispensable, except for the case where it is clearly specified in particular and where it is considered to be clearly indispensable from a theoretical point of view, etc.

Similarly, in the following embodiment, when shape, position relationship, etc. of an element etc. is referred to, what resembles or is similar to the shape substantially shall be included, except for the case where it is clearly specified in particular and where it is considered to be clearly not right from a theoretical point of view. This statement also applies to the numeric value and range described above.

In all the drawings for explaining the embodiment, the same symbol is attached to the same member, as a principle, and the repeated explanation thereof will be omitted. In order to make a drawing intelligible, hatching may be attached even if it is a plan view.

### Study for Improvement

The "related art" in the present specification is a technique including a problem newly found by the inventors and is not a known related art. However, the "related art" is a technique described considering a premise technique (unknown technique) of a new technical idea.

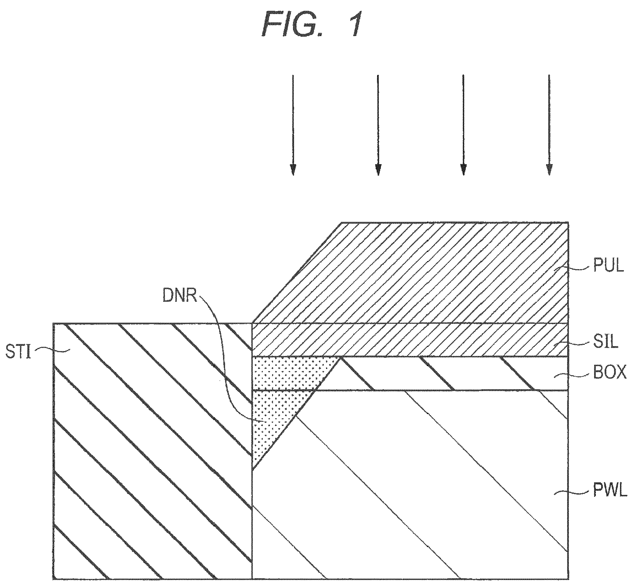

Fig. 1 is a schematic cross-sectional view illustrating room for improvement existing in a related art. In the related art shown in Fig. 1, a p-type well PWL is formed in an active region in a support substrate (substrate layer) partitioned by element isolation portions STI and a buried insulating layer BOX formed of, for example, a silicon oxide film with a film thickness of about 2 nm to 10 nm is formed over the p-type well PWL. A thin silicon layer SIL with a film thickness of about 10 to 15 nm is formed over the buried insulating layer BOX and a piled-up layer PUL with a film thickness of about 40 nm or less is formed over the silicon layer SIL. The piled-up layer PUL is formed by using, for example, a selective epitaxial method. According to study of the inventors, in the selective epitaxial method, epitaxial growth tends to be suppressed in a boundary region between the element isolation portion STI and the active region. As a result, a so-called "facet structure" is easily formed in which the closer to the element isolation region STI, the thinner the thickness of the piled-up layer PUL.

When the shape of the piled-up layer PUL becomes the "facet structure" as described above, there is room for improvement described below. In a related art, an n-type impurity (donor) DNR is introduced into the piled-up layer PUL and the silicon layer SIL formed below the piled-up layer PUL in order to form a source region or a drain region. The introduction of the n-type impurity DNR is performed by, for example, an ion implantation method. At this time, implantation energy of the n-type impurity DNR in the ion implantation method is set so that the n-type impurity DNR is introduced into the piled-up layer PUL and the silicon layer SIL. However, as shown in Fig. 1, in the related art, the shape of the piled-up layer PUL is the "facet structure", so that in a portion where the film thickness of the piled-up layer PUL is thin, the n-type impurity DNR is implanted into the buried insulating layer BOX formed below the silicon layer SIL and the p-type well PWL formed below the buried insulating layer BOX through the silicon layer SIL.

In this case, first, the impurity density of the portion where the film thickness of the piled-up layer PUL is thin is different from the impurity density of a portion where the film thickness of the piled-up layer PUL is uniform, so that the resistance values of the source region and the drain region are nonuniform and characteristic variation of the field-effect transistor tends to be large. As shown in Fig. 1, the n-type impurity DNR is implanted even into the buried insulating layer BOX, so that the buried insulating layer BOX tends to be easily damaged by the implantation energy at this time. As a result, the reliability of the buried insulating layer BOX tends to degrade. Further, as shown in Fig. 1, when the n-type impurity DNR is implanted even into the p-type well PWL, a region where the n-type impurity DNR is implanted changes from a p-type semiconductor region to an n-type semiconductor region and an unintended pn junction is formed in the p-type well PWL. When the pn junction is formed in the p-type well PWL in this way, there may be a risk of generation of a leakage current due to the pn junction, and thereby a risk of degradation of electrical characteristics of the semiconductor device increases.

From the above, it is known that in the related art, the shape of the piled-up layer PUL is the "facet structure" and thereby there is room of improvement from the viewpoint of reliability improvement and performance improvement of the semiconductor device. In other words, according to the study of the inventors, it is desired that the shape of the piled-up layer PUL is devised from the viewpoint of reliability improvement and performance improvement of the semiconductor device. Therefore, in the embodiment, the structure of the piled-up layer PUL is devised from the viewpoint of reliability improvement and performance improvement of the semiconductor device. Hereinafter, the technical idea of the embodiment devised as described above will be described. Structure of Semiconductor Device according to the Embodiment

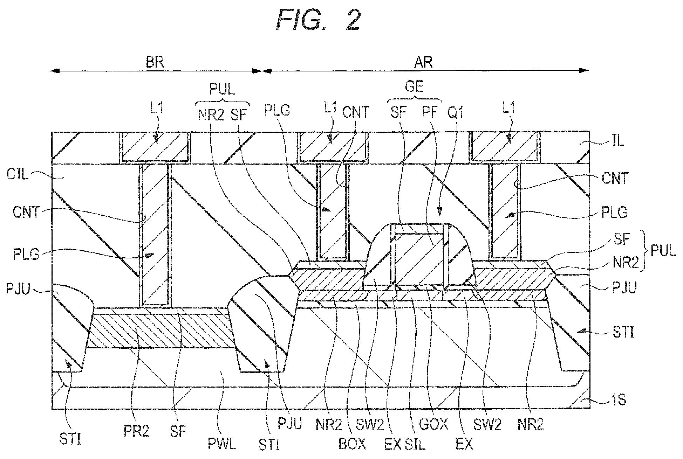

Fig. 2 is a cross-sectional view showing a device structure of the semiconductor device according to the embodiment. The semiconductor device according to the embodiment includes, for example, an n-channel type field-effect transistor and a p-channel type field-effect transistor. In particular, Fig. 2 shows a transistor formation region AR where an n-channel type field-effect transistor Q1 is formed and a power supply region BR that supplies power to a p-type well PWL.

First, in Fig. 2, a device structure formed in the transistor formation region AR will be described. As shown in Fig. 2, the p-type well PWL is formed in an SOI substrate formed of a support substrate (substrate layer) 1S, a buried insulating layer BOX, and a silicon layer SIL. The p-type well PWL is a p-type semiconductor region into which a p-type impurity (acceptor) such as, for example, boron (B) is introduced. The impurity density of the p-type well PWL is, for example, about 5×10¹⁷cm⁻³ to 5×10¹⁸cm⁻³.

Further, an element isolation portion STI is formed in the SOI substrate, and the n-channel type field-effect transistor Q1 is formed in an active region partitioned by the element isolation portions STI. Specifically, the element isolation portion STI is formed of a trench that penetrates the silicon layer SIL and the buried insulating layer BOX of the SOI substrate and reaches the support substrate 1S and an insulating film (for example, silicon oxide film) buried into the trench. The n-channel type field-effect transistor Q1 is formed from inside the silicon layer SIL of the SOI substrate partitioned by the element isolation portions STI to above the silicon layer SIL.

The n-channel type field-effect transistor Q1 includes a channel region formed in the silicon layer SI of the SOI substrate, a gate insulating film GOX formed over the channel region, a gate electrode GE formed over the gate insulating film GOX, and a sidewall spacer SW2 which is formed over both side walls of the gate electrode GE and which is formed of, for example, a silicon nitride film. Further, in the n-channel type field-effect transistor Q1, a pair of extension regions EX which are n-type semiconductor regions is formed in the silicon layer SIL so as to sandwich the channel region in the silicon layer SIL. Each of the pair of extension regions EX is formed to match the gate electrode GE. In the silicon layer SIL outside the extension region EX, an n-type semiconductor region NR2 whose impurity density is higher than that of the extension region EX is formed. The n-type semiconductor region NR2 is formed to match the sidewall spacer SW2. Here, for example, a piled-up layer PUL formed by the selective epitaxial method is formed over the n-type semiconductor region NR2 formed in the silicon layer SIL of the SOI substrate, and the n-type semiconductor region NR2 is also formed in the piled-up layer PUL. In other words, the n-type semiconductor region NR2 is formed from inside the silicon layer SIL of the SOI substrate to the piled-up layer PUL formed over the silicon layer SIL.

The gate insulating film GOX is formed of, for example, a silicon oxide film or a silicon nitride film. However, the gate insulating film GOX is not limited to this, and may be formed from a high dielectric constant film whose dielectric constant is higher than that of the silicon nitride film. Specifically, examples of the high dielectric constant film include metal oxide films such as a hafnium oxide film (HfO₂), a zirconium oxide film (ZrO₂), an aluminum oxide film (Al₂O₃), a tantalum oxide film (Ta₂O₅), and a lanthanum oxide film (La₂O₃). Further, as the gate insulating film GOX, it is possible to use a laminated film of a silicon oxide film and a high dielectric constant film and a laminated film of a silicon oxynitride film and a high dielectric constant film.

The gate electrode GE is formed of, for example, a polysilicon film whose resistance is lowered by introducing a conductive impurity. However, the gate electrode GE is not limited to the polysilicon film, but may be a metal film such as, for example, a titanium nitride film (TiN), a tantalum nitride film (TaN), a tungsten nitride film (WN), a titanium carbide film (TiC), a tantalum carbide film (TaC), a tungsten carbide film (WC), and a tantalum carbonitride film (TaCN). As the gate electrode GE, it is possible to employ an MIPS (Metal Inserted Poly-silicon Stack) structure which is a laminated structure of these metal films and a polysilicon film.

The extension region EX is an n-type semiconductor region into which an n-type impurity such as, for example, phosphorus (P) and arsenic (As) is introduced. The impurity density of the extension region EX is, for example, about 2×10¹⁹cm⁻³ or more, and in particular is desired to be about 1×10²⁰cm⁻³ or more. On the other hand, the n-type semiconductor region NR2 is also a semiconductor region into which an n-type impurity such as, for example, phosphorus (P) and arsenic (As) is introduced. The impurity density of the n-type semiconductor region NR2 is higher than that of the extension region EX and is, for example, 5×10²⁰cm⁻³ or more.

In the embodiment, the source region of the n-channel type field-effect transistor Q1 is formed by one (left) extension region EX and one (left) n-type semiconductor region NR2. Similarly, the drain region of the n-channel type field-effect transistor Q1 is formed by the other (right) extension region EX and the other (right) n-type semiconductor region NR2. Thereby, according to the n-channel type field-effect transistor of the embodiment, it is possible to form the source region and the drain region having an LDD (Lightly Doped Drain) structure. In particular, in the embodiment, the piled-up layer PUL also functions as the source region and the drain region, so that it is possible to increase the film thickness of the source region and the drain region, and thereby it is possible to lower the resistances of the source region and the drain region.

Next, as shown in Fig. 2, a metal silicide film SF is formed over the surface of the gate electrode GE. Similarly, the metal silicide film SF is also formed over the surface of the piled-up layer PUL. The metal silicide film SF is formed of, for example, a cobalt silicide film or a nickel silicide film and is formed by a salicide technique (Self Aligned Silicide). Therefore, it can be said that the gate electrode GE is formed from a laminated film of a polysilicon film PF and the metal silicide film SF and each of the source region and the drain region is formed from the extension region EX, the n-type semiconductor region NR2, and the metal silicide film SF. Thereby, it is possible to lower the resistance of the gate electrode GE and it is also possible to lower the resistances of the source region and the drain region.

Next, as shown in Fig. 2, a contact interlayer insulating film CIL is formed so as to cover the n-channel type field-effect transistor Q1 formed over the SOI substrate. The contact interlayer insulating film CIL is formed from a single film of a silicon oxide film or a laminated film of a silicon nitride film and a silicon oxide film whose thickness is greater than that of the silicon nitride film. The upper surface of the contact interlayer insulating film CIL is flattened. A contact hole CNT is formed so as to penetrate the contact interlayer insulating film CIL. A conductive plug PLG is formed in the contact hole CNT. The plug PLG is electrically coupled to the piled-up layer PUL that forms a part of the source region and the drain region through, for example, the metal silicide film SF.

An interlayer insulating film IL formed of, for example, a silicon oxide film or a low dielectric constant film whose dielectric constant is lower than that of the silicon oxide film is formed over the contact interlayer insulating film CIL in which the plug PLG is buried. A wiring trench is formed in the interlayer insulating film IL and a wiring L1 is formed inside the wiring trench. The wiring L1 is electrically coupled to the plug PLG buried in the contact interlayer insulating film CIL. Therefore, the n-channel type field-effect transistor Q1 and the wiring L1 are electrically coupled together through the plug PLG. For example, the wiring L1 is assumed to be a copper wiring formed of a copper film (Cu) formed by a damascene technique. However, the wiring L1 is not limited to this, and an aluminum wiring formed of an aluminum film (Al) formed by a patterning technique can be used as the wiring L1. In the way as described above, a device structure including the n-channel type field-effect transistor Q1 is formed in the transistor formation region AR.

The n-channel type field-effect transistor Q1 according to the embodiment is formed over the SOI substrate, so that it is possible to obtain an advantage to be able to reduce the junction capacitance between the p-type well PWL formed in the support substrate 1S of the SOI substrate and the source region or the drain region of the n-channel type field-effect transistor Q1. In other words, in the SOI substrate, the buried insulating layer BOX is formed between the support substrate 1S where the p-type well PWL is formed and the silicon layer SIL where a part of the source region and the drain region of the n-channel type field-effect transistor Q1, so that it is possible to reduce the junction capacitance between the p-type well PWL and the source region or the drain region.

Further, the n-channel type field-effect transistor Q1 in the embodiment is formed from, for example, a fully-depleted transistor. The fully-depleted transistor is required to fully deplete a channel region during an ON operation, so that no conductive impurity is introduced into the channel region in the fully-depleted transistor. This means that it is possible to suppress the variation of the threshold voltage caused by the variation of the impurity density of the conductive impurity introduced into the channel region. In other words, no conductive impurity is introduced into the channel region in the fully-depleted transistor, so that it is possible to eliminate non-uniformity of the threshold voltage caused by the variation of the impurity density of the conductive impurity, and thereby the fully-depleted transistor has an advantage to be able to improve stability of the threshold voltage. Further, the fully-depleted transistor also has an advantage to have excellent short channel characteristics.

Next, in Fig. 2, a structure formed in the power supply region BR will be described. As shown in Fig. 2, in the power supply region BR, the p-type well PWL is formed in the support substrate 1S partitioned by the element isolation portions STI. As shown in Fig. 2, in the power supply region BR, the buried insulating layer BOX and the silicon layer SIL of the SOI substrate are removed and a p-type semiconductor region PR2 is formed over a surface region of the support substrate 1S so that the p-type semiconductor region PR2 is enclosed by the p-type well PWL. The metal silicide film SF is formed over a surface of the p-type semiconductor region PR2. Further, the contact interlayer insulating film CIL is formed so as to cover the metal silicide film SF. A contact hole CNT is formed so as to penetrate the contact interlayer insulating film CIL. A conductive plug PLG is formed in the contact hole CNT. The plug PLG is electrically coupled to the p-type well PWL formed in the support substrate 1S through, for example, the metal silicide film SF.

The interlayer insulating film IL is formed over the contact interlayer insulating film CIL in which the plug PLG is buried. A wiring trench is formed in the interlayer insulating film IL and a wiring L1 is formed inside the wiring trench. The wiring L1 is electrically coupled to the plug PLG buried in the contact interlayer insulating film CIL. Therefore, in the power supply region BR, the p-type well PWL and the wiring L1 are electrically coupled together through the plug PLG. For example, the wiring L1 is a copper wiring formed from a copper film (Cu) formed by the damascene technique. In the way as described above, a power supply structure to the p-type well PWL is formed in the power supply region BR. The p-type well PWL may be electrically coupled to, for example, a voltage generation circuit that applies a substrate bias through the plug PLG and the wiring L1. In this case, it is possible to apply the substrate bias to the p-type well PWL, and thereby it is possible to increase a variable range of the threshold voltage of the n-channel type field-effect transistor formed in the transistor formation region AR.

### Characteristics of the Embodiment

Next, a characteristic point of the embodiment will be described. For example, as shown in Fig. 2, the characteristic point of the embodiment is that the element isolation portion STI has a projection portion PJU projected from substantially the same height as the upper surface of the SOI substrate (the surface of the silicon layer SIL). In other words, the characteristic point of the embodiment is that the projection portion PJU that protrudes from the SOI substrate and comes into contact with the piled-up layer PUL is formed in the element isolation portion STI.

Thereby, as shown in Fig. 2, the piled-up layer PUL formed in the active region can secure the film thickness of the piled-up layer PUL even in a region close to the boundary region between an end portion of the active region and the element isolation portion STI. That is to say, according to the characteristic point of the embodiment, it is possible to substantially equalize the film thickness of the piled-up layer PUL from a portion in contact with a side wall of the sidewall spacer SW2 to a portion in contact with the projection portion PJU of the element isolation portion STI. In other words, according to the characteristic point of the embodiment, it is possible to prevent the piled-up layer PUL from being the "facet structure" in a region close to the boundary region between the end portion of the active region and the element isolation portion STI.

The fundamental thought of the embodiment is, for example, as shown in Fig. 1, when the piled-up layer PUL is formed over the flat piled-up layer PUL by the selective epitaxial growth method, the structure of the piled-up layer PUL becomes the "facet structure" in a region close to the boundary region between the end portion of the active region and the element isolation portion STI from a relation of an orientation in which silicon is easily grown and a relation of magnitude of growth energy. However, as shown in Fig. 2, at the other end portion where the sidewall spacer SW2 exists, the piled-up layer PUL is formed so as to in contact with the sidewall spacer SW2. The inventors focus on this point. Specifically, for example, when there is a wall portion such as the sidewall spacer SW2, the piled-up layer PUL grows beginning from the wall portion. As known by seeing a portion close to the side wall of the sidewall spacer SW2 in Fig. 2, when there is a wall portion from which the epitaxial growth starts, the "facet structure" is prevented from being formed. Therefore, also in a region close to the boundary region between the end portion of the active region and the element isolation portion STI, if there is a wall portion from which the epitaxial growth starts, it is considered that the epitaxial growth of silicon proceeds and formation of the "facet structure" is suppressed. This is the fundamental thought of the embodiment. Specifically, the fundamental thought of the embodiment is a thought to provide a wall portion from which the epitaxial growth starts in a region close to the boundary region between the end portion of the flat active region and the element isolation portion STI. In the embodiment, as a means to embody the fundamental thought, the characteristic point of the embodiment described above is employed. That is to say, a starting point from which the silicon grows is formed on purpose by providing the projection portion PJU projected from substantially the same height as the upper surface of the SOI substrate in the element isolation portion STI, and the silicon is also caused to epitaxially grow from the starting point. As a result, in the embodiment, the projection portion PJU formed in the element isolation portion STI functions as a wall portion in a region close to the boundary region between the end portion of the flat active region and the element isolation portion STI.

Thereby, according to the embodiment, in a region close to the boundary region between the end portion of the active region and the element isolation portion STI, the projection portion PJU of the element isolation portion STI functions as a wall portion in the same manner as the sidewall spacer SW2. Because of this, as shown in Fig. 2, it is possible to substantially equalize the film thickness of the piled-up layer PUL from a portion in contact with a side wall of the sidewall spacer SW2 to a portion in contact with the projection portion PJU of the element isolation portion STI. As a result, according to the embodiment, the "facet structure" is not formed in the piled-up layer PUL in a region close to the boundary region between the end portion of the active region and the element isolation portion STI, so that it is possible to prevent a conductive impurity from being introduced into the buried insulating layer BOX of the SOI substrate and the support substrate 1S due to the "facet structure". This means that it is possible to prevent the buried insulating layer BOX from being damaged due to introduction of the conductive impurity and the pn junction that is a generation source of leakage current is prevented from being formed in the support substrate 1S. Therefore, according to the embodiment, it is possible to suppress film quality deterioration of the buried insulating layer BOX of the SOI substrate and it is possible to suppress increase of leakage current in the support substrate 1S of the SOI substrate. Because of this, according to the embodiment, it is possible to improve the reliability and the performance of the semiconductor device.

In the embodiment, the "facet structure" is not formed at an end portion of the piled-up layer PUL, so that the volume of the piled-up layer PUL can be increased by the volume of the "facet structure" without increasing the plane area (plane size) of the piled-up layer PUL. This means that it is possible to lower the resistances of the source region and the drain region of the n-channel type field-effect transistor Q1 without sacrificing downsizing of the semiconductor device, and because of this, it is possible to lower a parasitic resistance of the n-channel type field-effect transistor Q1. Therefore, according to the embodiment, it is also possible to improve the performance of the semiconductor device from this point.

A direct characteristic point of the embodiment is that the element isolation portion STI has the projection portion PJU projected from substantially the same height as the upper surface of the SOI substrate (the surface of the silicon layer SIL). The direct characteristic point also appears as a point that no conductive impurity is introduced in the buried insulating layer BOX of the SOI substrate and a point that no pn junction is formed in the p-type well PWL formed in the support substrate 1S of the SOI substrate.

Further, a characteristic point of the embodiment is that the height of the upper surface of the projection portion PJU is lower than or equal to the height of the upper surface of the piled-up layer PUL and higher than or equal to a half of the height of the upper surface of the piled-up layer PUL with reference to the surface of the silicon layer SIL of the SOI substrate. For example, from a viewpoint of securing uniformity of the film thickness of the piled-up layer PUL from the side wall of the sidewall spacer SW2 to a boundary region between the piled-up layer PUL and the element isolation portion STI, it is considered that the height of the projection portion PJU formed in the element isolation portion STI is set to about the same as the film thickness (designed film thickness) of the piled-up layer PUL. On the other hand, when the height of the projection portion PJU is increased, the unevenness of the surface of the SOI substrate increases. In this case, for example, it is difficult to focus on the entire unevenness of the SOI substrate, so that defocusing occurs in a photolithography technique. This means that it is difficult to perform patterning in a focused state. Therefore, in order to secure uniformity of the film thickness of the piled-up layer PUL from the side wall of the sidewall spacer SW2 to the boundary region between the piled-up layer PUL and the element isolation portion STI, a configuration in which the projection portion PJU is provided over the element isolation portion STI is effective. However, when the height of the projection portion PJU is too high, a problem appears that the accuracy of patterning degrades. Therefore, in the embodiment, the uniformity of the film thickness of the piled-up layer PUL is managed to be secured from the side wall of the sidewall spacer SW2 to the boundary region between the piled-up layer PUL and the element isolation portion STI without increasing the height of the projection portion PJU formed over the element isolation portion STI as much as possible.

Specifically, in the embodiment, for example, as shown in Fig. 2, it is devised so that an end portion of the projection portion PJU is formed into a tapered shape from the boundary region between the element isolation portion STI and the active region toward the element isolation portion STI.

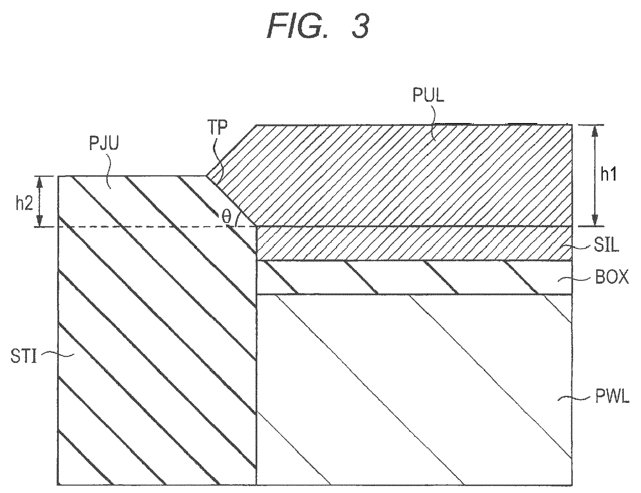

Fig. 3 is an enlarged schematic cross-sectional view showing a region close to the boundary region between the element isolation portion STI and the active region. As shown in Fig. 3, the projection portion PJU is provided so as to project upward from the element isolation portion STI with reference to the surface of the silicon layer SIL. The end portion of the projection portion PJU has a tapered shape. Thereby, as shown in Fig. 3, while the height h2 of the projection portion PJU is set to lower than the height h1 of the piled-up layer PUL, it is possible to set the film thickness of the end portion of the piled-up layer PUL to about the same as the film thickness of the other portion of the piled-up layer PUL. In other words, the projection portion PJU has an inclined surface that is continuously inclined upward and in a direction toward the center of the element isolation portion STI, and the piled-up layer PUL is formed along the inclined surface. After the piled-up layer PUL reaches the upper surface of the element isolation portion STI, the piled-up layer PUL is formed so as to be continuously inclined upward and in a direction away from the element isolation portion STI. In other words, the piled-up layer PUL is formed along the shape of the element isolation portion STI in a lower region lower than the upper surface of the element isolation portion STI, and the piled-up layer PUL forms the "facet structure" in an upper region higher than the upper surface of the element isolation portion STI. In this way, in the embodiment, by providing the tapered shape at the end portion of the projection portion PJU, it is possible to secure the film thickness at the end portion of the piled-up layer PUL without unnecessarily increasing the height of the projection portion PJU. Therefore, according to the embodiment, it is possible to secure the film thickness at the end portion of the piled-up layer PUL while preventing a side effect which is degradation of the patterning accuracy due to the presence of the projection portion PJU.

For example, in the embodiment, when a taper angle θ of the tapered shape is set to 45° or more, even if the film thickness is smaller than or equal to the height of the upper surface of the piled-up layer PUL and greater than or equal to a half of the height of the upper surface of the piled-up layer PUL, it is possible to set the film thickness of the end portion of the piled-up layer PUL to about the same as the film thickness of the other portion of the piled-up layer PUL.

### Modified Example 1

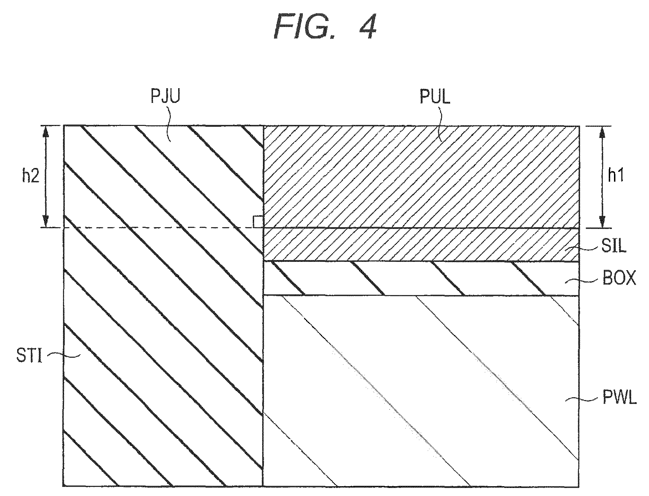

The technical idea of the embodiment can also be embodied as a configuration of a modified example 1 described below. Fig. 4 is an enlarged schematic cross- sectional view showing a region close to a boundary region between an element isolation portion STI and an active region in the modified example 1. As shown in Fig. 4, a projection portion PJU is provided so as to project upward from the element isolation portion STI with reference to a surface of a silicon layer SIL. The end surface of the projection portion PJU is a vertical surface. Also in the modified example 1 configured in this way, it is possible to set the film thickness of the end portion of the piled-up layer PUL to about the same as the film thickness of the other portion of the piled-up layer PUL. In other words, the height h2 of the projection portion PJU can be set to about the same as the thickness h1 of the piled-up layer PUL. Thereby, also in the modified example 1, the end portion of the piled-up layer PUL does not have the "facet structure", so that the conductive impurity is prevented from being implanted into the buried insulating layer BOX and the p-type well PWL. As a result, also in the modified example 1, it is possible to improve the reliability and the performance of the semiconductor device.

### Modified Example 2

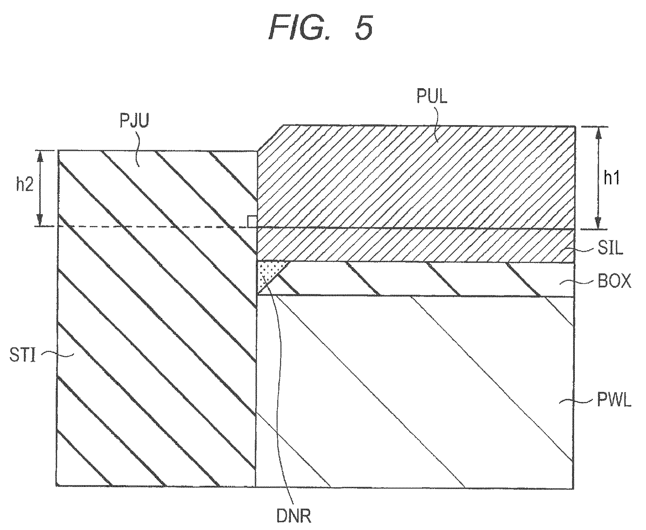

The technical idea of the embodiment can also be embodied as a configuration of a modified example 2 described below. Fig. 5 is an enlarged schematic cross-sectional view showing a region close to a boundary region between an element isolation portion STI and an active region in the modified example 2. As shown in Fig. 5, a projection portion PJU is provided so as to project upward from the element isolation portion STI with reference to a surface of a silicon layer SIL. The end surface of the projection portion PJU is a vertical surface. Here, in the modified example 2, on the premise that the end portion of the projection portion PJU has a vertical shape, for example, the height h2 of the projection portion PJU is lower than the height h1 of the piled-up layer PUL by the film thickness of the buried insulating layer BOX. Also in the modified example 2 configured in this way, it is possible to set the film thickness of the end portion of the piled-up layer PUL to about the same as the film thickness of the other portion of the piled-up layer PUL. Thereby, also in the modified example 2, the end portion of the piled-up layer PUL does not have the "facet structure", so that the conductive impurity is prevented from being implanted into the buried insulating layer BOX and the p-type well PWL. In other words, the piled-up layer PUL is formed along the side surface of the element isolation portion STI. After the piled-up layer PUL reaches the upper surface of the element isolation portion STI, the piled-up layer PUL is formed so as to be continuously inclined upward and in a direction away from the element isolation portion STI. In other words, the piled-up layer PUL is formed along the shape of the element isolation portion STI in a lower region lower than the upper surface of the element isolation portion STI, and the piled-up layer PUL forms the "facet structure" in an upper region higher than the upper surface of the element isolation portion STI. As a result, also in the modified example 2, it is possible to improve the reliability and the performance of the semiconductor device.

However, in the modified example 2, the height h2 of the projection portion PJU is lower than the height h1 of the piled-up layer PUL by the film thickness of the buried insulating layer BOX. Therefore, in an introduction process of the conductive impurity, the conductive impurity is also introduced into the buried insulating layer BOX of the SOI substrate, so that the buried insulating layer BOX may be damaged. However, also in the modified example 2, the conductive impurity is at least prevented from being implanted into the p-type well PWL. That is to say, also in the modified example 2, it is possible to prevent the generation of leakage current caused by formation of unintended pn junction due to introduction of conductive impurity into the p-type well PWL. Therefore, at least in this point, it is possible to improve the performance of the semiconductor device. In the modified example 2, the height h2 of the projection portion PJU may be as high as that of the modified example 1.

### Manufacturing Method of Semiconductor Device according to the Embodiment

The semiconductor device according to the embodiment is configured as described above and the manufacturing method of the semiconductor device will be described below with reference to the drawings.

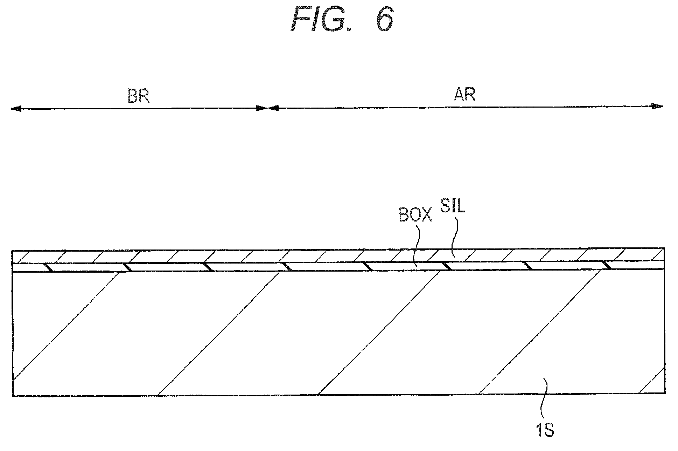

First, as shown in Fig. 6, the SOI substrate including the support substrate 1S, the buried insulating layer BOX formed over the support substrate 1S, and the silicon layer SIL formed over the buried insulating layer BOX is prepared. Such an SOI substrate can be manufactured by using, for example, an oxygen injection technique and/or a lamination technique.

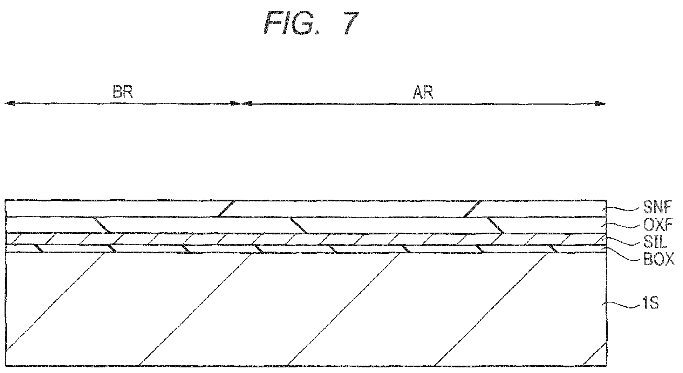

Next, as shown in Fig. 7, a silicon oxide film OXF is formed over the silicon layer SIL of the SOI substrate by using, for example, a CVD (Chemical Vapor Deposition) method and a silicon nitride film SNF is formed over the silicon oxide film OXF.

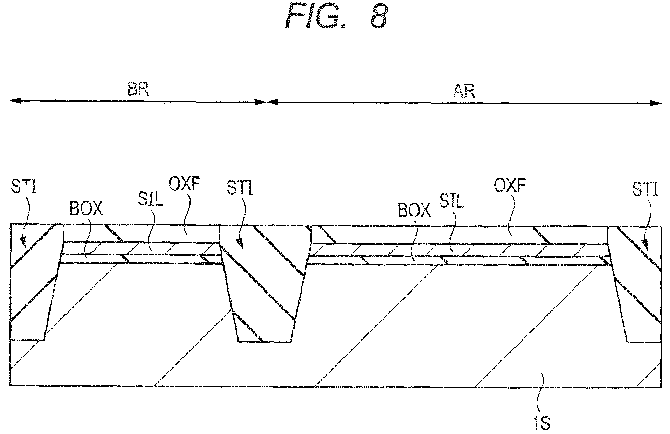

Thereafter, as shown in Fig. 8, the element isolation portion STI that penetrates the silicon oxide film OXF, the silicon layer SIL, and the buried insulating layer BOX, and reaches the support substrate 1S is formed in the SOI substrate. Specifically, a trench is formed in the SOI substrate by using a photolithography method and a dry etching method and an inner wall of the trench is oxidized, and thereafter a silicon oxide film is buried inside the trench. Then, the silicon nitride film SNF is polished by using a chemical mechanical polishing (CMP) method.

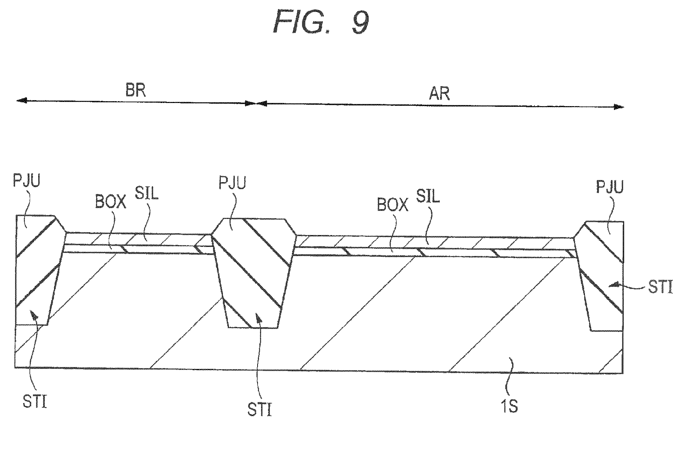

Subsequently, as shown in Fig. 9, the silicon oxide film OXF is removed by using, for example, a wet etching method. At this time, the silicon oxide film buried in the trench is formed of a film denser than the silicon oxide film OXF formed over the silicon layer SIL, so that the silicon oxide film buried in the trench is more difficult to be etched than the silicon oxide film OXF. As a result, as shown in Fig. 9, when the silicon oxide film OXF is removed, the projection portion PJU is formed in the element isolation portion STI and a tapered shape is formed at an end portion of the projection portion PJU. In short, the projection portion PJU projected from the SOI substrate is formed in the element isolation portion STI by etching the silicon oxide film OXF. At this time, the height of the projection portion PJU is decided according to the film thickness of the silicon oxide film OXF formed over the silicon layer SIL. Thus, it is possible to control the height of the projection portion PJU by appropriately setting the film thickness of the silicon oxide film OXF formed in a step of Fig. 7.

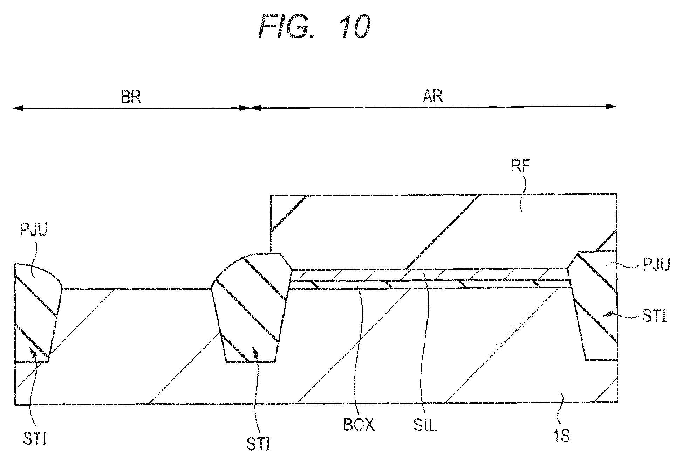

Next, as shown in Fig. 10, a resist film RF is coated over the SOI substrate and then the resist film RF is patterned by using a photolithography technique. The patterning of the resist film RF is performed so as to cover the transistor formation region AR of the SOI substrate and expose the power supply region BR of the SOI substrate. Then, the silicon layer SIL of the SOI substrate exposed to the power supply region BR and the buried insulating layer BOX formed below the silicon layer SIL are removed by an etching technique using the patterned resist film RF as a mask. Thereby, the surface of the support substrate 1S of the SOI substrate is exposed in the power supply region BR. Then, the resist film RF is removed.

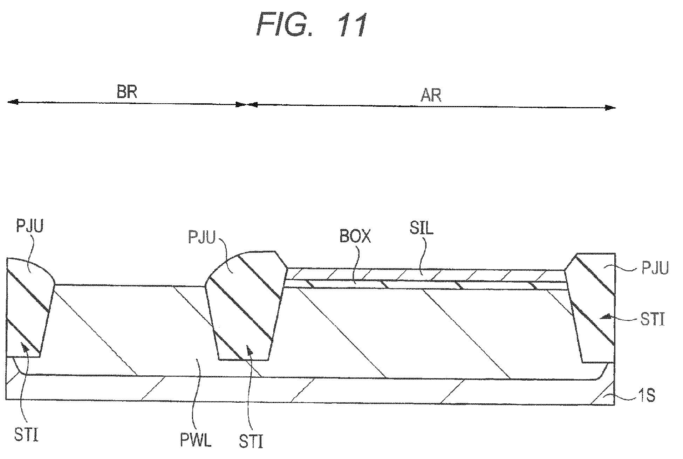

Thereafter, as shown in Fig. 11, a p-type impurity is introduced in the support substrate 1S of the SOI substrate by using a photolithography technique and an ion implantation method. Thereby, the p-type well PWL is formed in the support substrate 1S of the SOI substrate. The p-type well PWL is formed over a region from the transistor formation region AR to the power supply region BR.

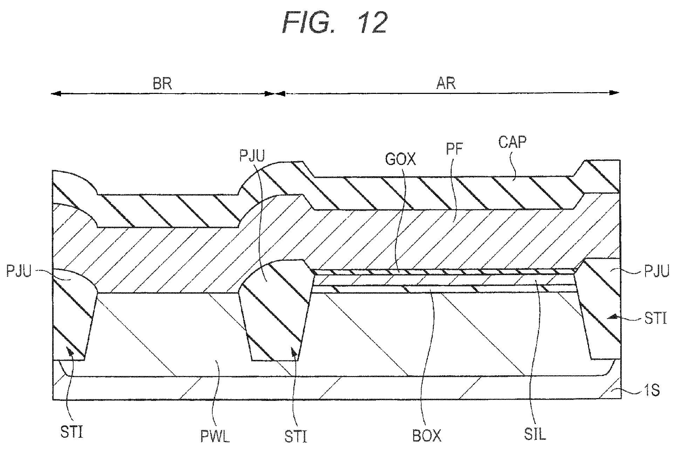

Subsequently, as shown in Fig. 12, in the transistor formation region AR, the gate insulating film GOX is formed over the silicon layer SIL in the active region partitioned by the element isolation portions STI. The gate insulating film GOX is formed of, for example, a silicon oxide film. The thickness of the gate insulating film GOX is about 2 nm to 10 nm. As the gate insulating film GOX, a high dielectric constant film may be used instead of the silicon oxide film as described above. Then, by using, for example, the CVD method, a polysilicon film PF is formed from over the gate insulating film GOX formed in the transistor formation region AR to over the support substrate 1S exposed to the power supply region BR, and a cap film CAP formed of, for example, a silicon nitride film is formed over the polysilicon film PF.

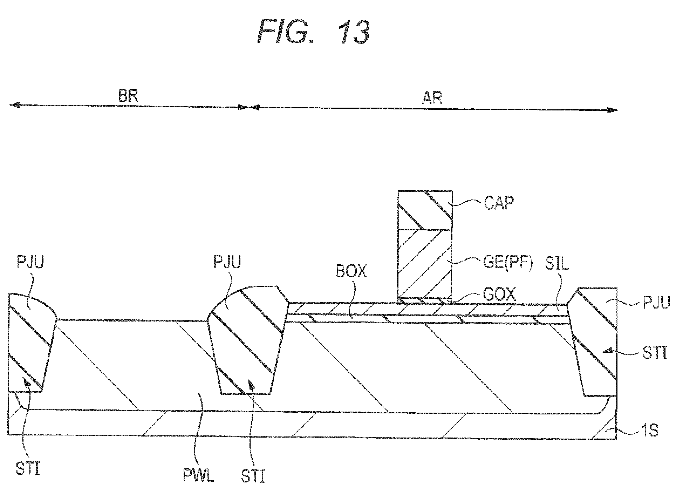

Thereafter, as shown in Fig. 13, the gate electrode GE formed of the polysilicon film PF and the cap film CAP formed over the gate electrode GE are formed by patterning the cap film CAP and the polysilicon film PF by using a photolithography technique and an etching technique. As the gate electrode GE, a metal film or a laminated film of a metal film and a polysilicon film may be used instead of the polysilicon film as described above.

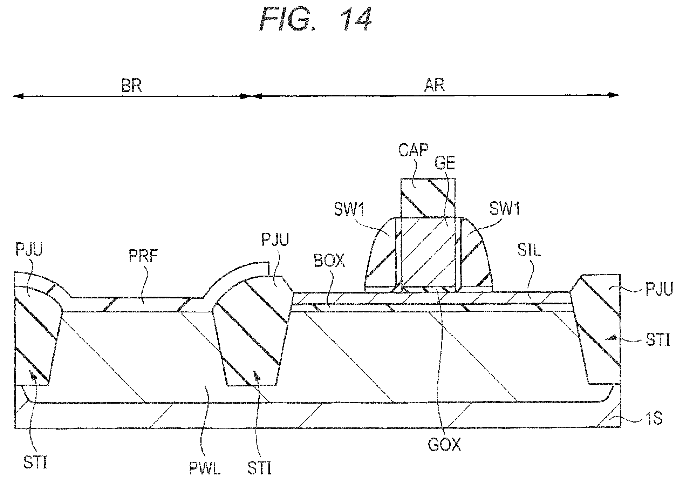

Next, as shown in Fig. 14, a silicon oxide film and a silicon nitride film are deposited over the SOI substrate so as to cover the cap film CAP and the gate electrode GE and thereafter the silicon oxide film and the silicon nitride film are etched back, so that a sidewall spacer SW1 is formed over both side walls of the gate electrode GE. At this time, in the power supply region BR, the surface of the support substrate 1S of the SOI substrate is covered by a protective film PRF formed of a silicon nitride film.

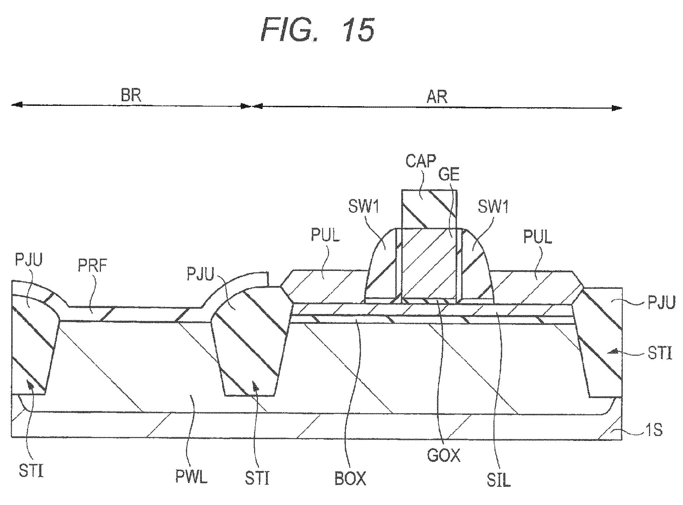

Subsequently, as shown in Fig. 15, by using a selective epitaxial method, the piled-up layer PUL formed of silicon is formed over the silicon layer SIL of the SOI substrate exposed in the transistor formation region AR. At this time, as shown in Fig. 15, silicon grows from the exposed silicon layer SIL and also silicon grows from the side wall of the sidewall spacer SW1. Further, in the embodiment, the projection portion PJU is provided in the element isolation portion STI and silicon also grows from an end portion (tapered portion) of the projection portion PJU.

As a result, as shown in Fig. 15, the piled-up layer PUL having substantially the same film thickness from the side wall of the sidewall spacer SW1 to the projection portion PJU of the element isolation portion STI is formed. For example, the film thickness of the piled-up layer PUL is about 40 nm or less. At this time, the piled-up layer PUL is formed so that the piled-up layer PUL is in contact with the projection portion PJU and the height of the upper surface of the piled-up layer PUL is higher than the height of the upper surface of the projection portion PJU and lower than or equal to two times the height of the upper surface of the projection portion PJU with reference to the surface of the silicon layer SIL. In the power supply region BR, the surface of the support substrate 1S is covered by the protective film PRF, so that no silicon grows from the surface or the support substrate 1S. In other words, the protective film PRF formed in the power supply region BR has a function to prevent silicon from growing.

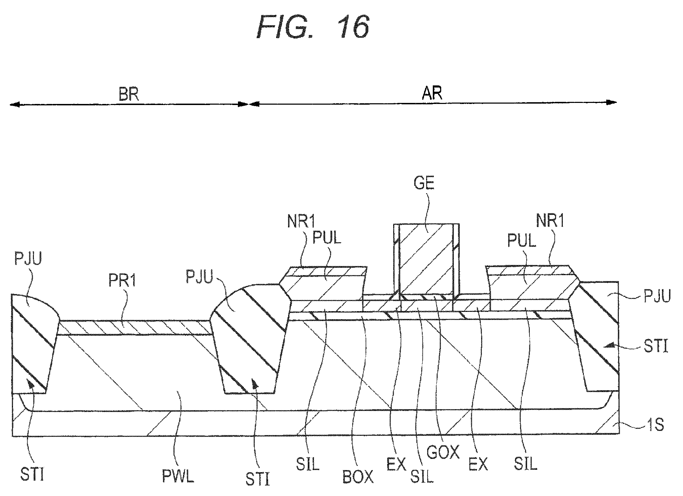

Thereafter, as shown in Fig. 16, the sidewall spacer SW1 formed over both side surfaces of the gate electrode GE is removed. At this time, the cap film CAP is also removed. Then, a conductive impurity (n-type impurity) is introduced into the silicon layer SIL that is exposed by removing the sidewall spacer SW1 and a part of the piled-up layer PUL with an implantation energy of 10 keV or less and with a first dose amount (1×10¹⁵cm⁻²). Thereby, a pair of extension regions EX matching the gate electrode GE are formed so as to sandwich the channel region existing below the gate electrode GE. Similarly, an n-type semiconductor region NR1 is formed over the surface of the piled-up layer PUL. Further, a p-type semiconductor region PR1 is formed over the p-type well PWL in the power supply region BR in another process. The p-type semiconductor region PR2 is formed in a later process, so that it is possible to omit the p-type semiconductor region PR1.

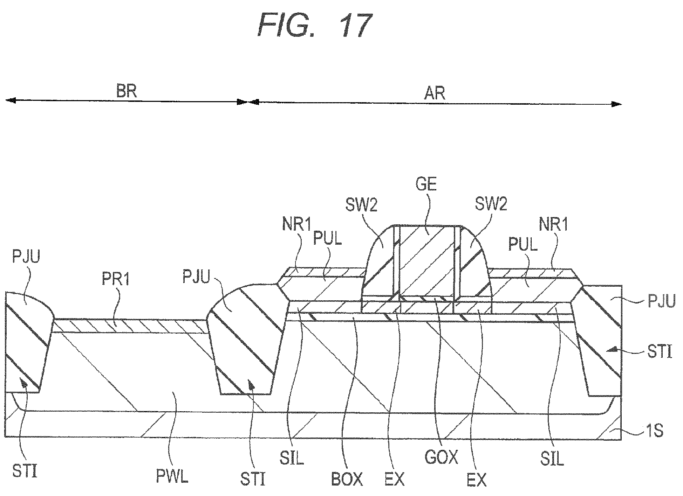

Next, as shown in Fig. 17, a silicon nitride film is deposited over the SOI substrate and thereafter the silicon nitride film is etched back, so that the sidewall spacer SW2 (replacement sidewall spacer) is formed again over the side wall of the gate electrode GE.

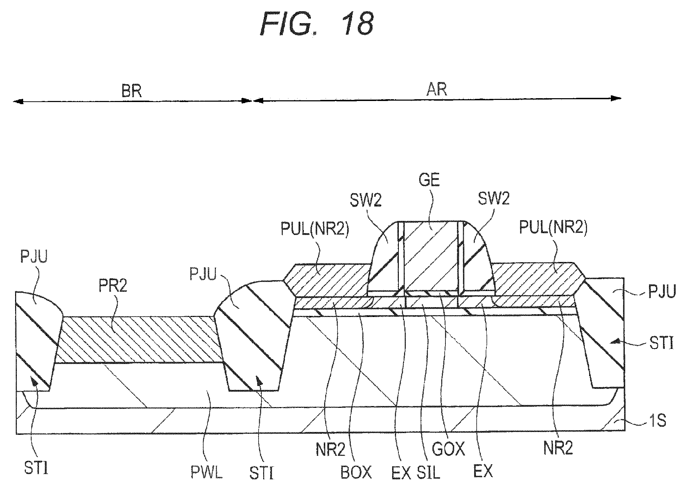

Then, as shown in Fig. 18, a conductive impurity (n-type impurity) is introduced into the piled-up layer PUL and the silicon layer SIL located below the piled-up layer PUL with a second dose amount greater than the first dose amount by using a photolithography technique and an ion implantation method. Thereby, the n-type semiconductor region NR2 is formed in the piled-up layer PUL and the silicon layer SIL located below the piled-up layer PUL. As a result, the source region is formed by one (left) extension region EX and one (left) n-type semiconductor region NR2 and the drain region is formed by the other (right) extension region EX and the other (right) n-type semiconductor region NR2. In the power supply region BR, the p-type semiconductor region PR2 is formed over the surface of the support substrate 1S in another process. The p-type semiconductor region PR2 is an impurity region whose impurity density is higher than that of the p-type semiconductor region PR1.

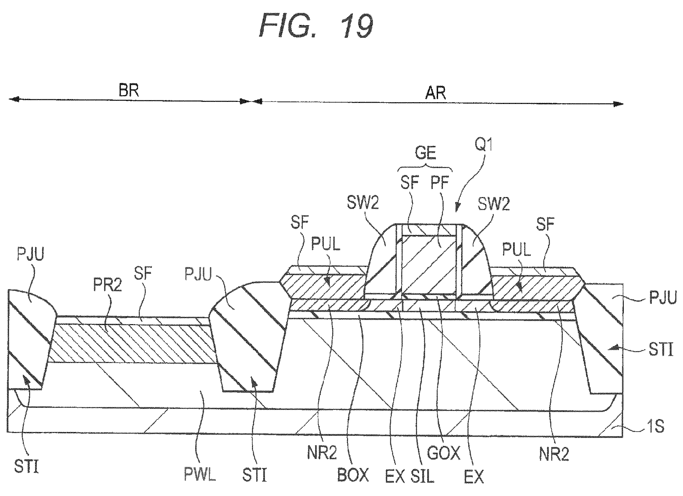

Subsequently, as shown in Fig. 19, the metal silicide film SF is formed over the surface of the gate electrode GE and the metal silicide film SF is also formed over the surface of the piled-up layer PUL. Similarly, the metal silicide film SF is also formed over the surface of the p-type semiconductor region PR2 formed in the power supply region BR. Specifically, the metal silicide film SF is formed of, for example, a cobalt silicide film, a nickel silicide film, and a platinum silicide film. The metal silicide film SF can be formed by, for example, performing a silicide reaction between a metal film and silicon by forming a metal film so as to cover the SOI substrate and then applying heat treatment to the SOI substrate by using a sputtering method. In this way, it is possible to form the n-channel type field-effect transistor Q1 in the transistor formation region AR of the SOI substrate.

Thereafter, a wiring process is performed. Specifically, as shown in Fig. 2, the contact interlayer insulating film CIL is formed so as to cover the SOI substrate over the transistor formation region AR where the n-channel type field-effect transistor Q1 is formed and the power supply region BR. The contact interlayer insulating film CIL is formed, for example, from a silicon oxide film or a laminated film of a silicon nitride film and a silicon oxide film and can be formed by using, for example, a CVD method.

Then, the plug PLG is formed by forming the contact hole CNT penetrating the contact interlayer insulating film CIL by using a photolithography technique and an etching technique and thereafter burying a barrier conductor film and a tungsten film in the contact hole CNT. In particular, also in the power supply region BR, the plug PLG coupling to the p-type semiconductor region PR2 is formed and thereby a power supply structure is formed.

Next, the interlayer insulating film IL formed of a silicon oxide film or a low dielectric constant film is formed over the contact interlayer insulating film CIL, where the plug PLG is formed, by using, for example, a CVD method. Thereafter, a wiring trench is formed in the interlayer insulating film IL by using a photolithography technique and an etching technique. Subsequently, a barrier conductor film and a copper film are buried in the wiring trench and unnecessary barrier conductor film and copper film formed over the interlayer insulating film IL are removed by, for example, a CMP method (damascene technique). Thereby, it is possible to form the wiring L1 formed of a copper wiring buried in the interlayer insulating film IL. Thereafter, further, multilayer wiring is formed over the interlayer insulating film IL. However, description of this process is omitted. By doing as described above, it is possible to manufacture the semiconductor device according to the embodiment.

While the invention made by the inventors has been specifically described based on the embodiment, it is needless to say that the present invention is not limited to the embodiment and may be variously modified without departing from the scope of the invention.

## Claims

1. A semiconductor device comprising:
an SOI substrate including a substrate layer, an insulating layer formed over the substrate layer, and a silicon layer formed over the insulating layer;
an element isolation portion that penetrates the silicon layer and the insulating layer and reaches the substrate layer; and
a field-effect transistor formed in an active region partitioned by the element isolation portion,
wherein the field-effect transistor includes
a channel region in the silicon layer,
a gate insulating film formed over the channel region,
a gate electrode formed over the gate insulating film, and
a piled-up layer formed over the silicon layer,
wherein the element isolation portion includes a projection portion that projects from the SOI substrate and comes into contact with the piled-up layer, and
wherein a height of an upper surface of the projection portion is lower than or equal to a height of an upper surface of the piled-up layer and higher than or equal to a half of the height of the upper surface of the piled-up layer with reference to a surface of the silicon layer.

2. The semiconductor device according to claim 1,
wherein an end portion of the projection portion has a tapered shape, wherein a taper angle of the tapered shape preferably is 45° or more.

3. The semiconductor device according to claim 1 or 2,
wherein an end surface of the projection portion is a vertical surface.

4. The semiconductor device according to one of claims 1 to 3,
wherein the height of the upper surface of the projection portion is lower than the upper surface of the piled-up layer by a thickness of the insulating layer with reference to the surface of the silicon layer.

5. The semiconductor device according to one of claims 1 to 4,
wherein the piled-up layer forms a part of a source region of the field-effect transistor or a part of a drain region of the field-effect transistor.

6. The semiconductor device according to one of claims 1 to 5,
wherein a conductive impurity is introduced in the piled-up layer.

7. The semiconductor device according to one of claims 1 to 6,
wherein no conductive impurity is introduced in the insulating layer.

8. The semiconductor device according to one of claims 1 to 7,
wherein a silicide film is formed over the upper surface of the piled-up layer, and
wherein the piled-up layer is electrically coupled with a plug through the silicide film, and.
wherein the field-effect transistor preferably is a fully-depleted transistor.

9. A manufacturing method of a semiconductor device, comprising the steps of:
(a) preparing an SOI substrate including a substrate layer, an insulating layer formed over the substrate layer, and a silicon layer formed over the insulating layer;
(b) forming a first insulating film over the silicon layer;
(c) after the step (b), forming an element isolation portion that penetrates the first insulating film, the silicon layer, and the insulating layer and reaches the substrate layer in the SOI substrate;
(d) after the step (c), forming a projection portion projected from the SOI substrate in the element isolation portion by etching the first insulating film;
(e) after the step (d), forming a gate insulating film over the silicon layer in an active region partitioned by the element isolation portion;
(f) forming a gate electrode over the gate insulating film;
(g) after the step (f), forming a piled-up layer over the silicon layer; and
(h) after the step (g), introducing a conductive impurity into the piled-up layer,
wherein in the step (g),
the piled-up layer comes into contact with the projection portion, and
a height of an upper surface of the piled-up layer is higher than a height of an upper surface of the projection portion and lower than or equal to two times the height of the upper surface of the projection portion with reference to a surface of the silicon layer.

10. The manufacturing method of a semiconductor device according to claim 9,
wherein the step (g) forms the piled-up layer over the silicon layer by using a selective epitaxial method, and/or
wherein the step (d) forms the projection portion projected from the SOI substrate in the element isolation portion by wet-etching the first insulating film.

11. The manufacturing method of a semiconductor device according to claim 9 or 10, further comprising:
(i) between the step (f) and the step (g), forming a first sidewall over a side wall of the gate electrode,
wherein the step (h) includes
(h1) removing the first sidewall,
(h2) introducing the conductive impurity into the silicon layer exposed by removing the first sidewall and a part of the piled-up layer with a first dose amount,
(h3) after the step (h2), forming a second sidewall over the side wall of the gate electrode, and
(h4) after the step (h3), introducing the conductive impurity into the piled-up layer and the silicon layer located below the piled-up layer with a second dose amount greater than the first dose amount.

12. A semiconductor device comprising:
an SOI substrate including a substrate, an insulating layer formed over the substrate, and a silicon layer formed over the insulating layer;
an element isolation portion that penetrates the silicon layer and the insulating layer and reaches the substrate; and
a field-effect transistor formed in the silicon layer partitioned by the element isolation portion,
wherein a piled-up layer including silicon is formed over the silicon layer between a gate electrode of the field-effect transistor and the element isolation portion,
wherein the element isolation portion includes a projection portion projecting with reference to a surface of the silicon layer,
wherein an inclined surface that is continuously inclined upward and in a direction toward a center of the element isolation portion is formed at an end portion of the projection portion, and
wherein the piled-up layer is formed along the inclined surface.

13. The semiconductor device according to claim 12,
wherein the piled-up layer is formed along the element isolation portion in a lower region lower than an upper surface of the element isolation portion and forms a facet structure in an upper region higher than the upper surface of the element isolation portion.

14. The semiconductor device according to claim 12 or 13,
wherein the facet structure has a portion that is formed so as to be continuously inclined upward and in a direction away from the element isolation portion.

15. The semiconductor device according to one of claims 12 to 14,
wherein an impurity is introduced into the piled-up layer and the silicon layer below the piled-up layer, so that a part of a source region of the field-effect transistor or a part of a drain region of the field-effect transistor is formed.
